(19) Europäisches Patentamt

European Patent Office

Office européen des brevets

(11) **EP 1 724 785 A1**

(12) **EUROPEAN PATENT APPLICATION**

(43) Date of publication:
**22.11.2006 Bulletin 2006/47**

(51) Int Cl.:
***G11C 13/00*** (2006.01)  ***G11C 11/401*** (2006.01)

(21) Application number: **05010955.2**

(22) Date of filing: **20.05.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicant: **Max-Planck-Gesellschaft zur Förderung der Wissenschaften e.V.**
**80539 München (DE)**

(72) Inventors:
• **Alexe, Marin**
 **06120 Halle (DE)**
• **Gösele, Ulrich M.**
 **06114 Halle (DE)**

(74) Representative: **Patentanwälte Lambsdorff & Lange**
**Dingolfinger Strasse 6**
**81673 München (DE)**

(54) **A nanowire-based memory capacitor and memory cell and methods for fabricating them**

(57)    A nanowire-based memory capacitor (20) is comprised of a substrate (11), nanowires (12) attached to a portion of the surface of the substrate (11), wherein the nanowires (12) are oriented substantially perpendicular to the surface of the substrate (11) and the nanowires (12) are made of an electrically conductive or semi-conductive material, in particular silicon, and thus form a lower electrode of the capacitor (20), and a capacitor insulation layer (13) is deposited conformally onto the nanowires (12), and a layer (14) of an electrically conductive material is deposited conformally onto the capacitor insulation layer (13) thus forming an upper electrode of the capacitor (20).

Fig. 1

EP 1 724 785 A1

**Description**

The present invention relates to a nanowire-based memory capacitor, a memory cell comprising a nanowire-based memory capacitor, a method for fabricating a nanowire-based memory capacitor and a method for fabricating a memory cell comprising a nanowire-based memory capacitor.

Nowadays the widely spread computer memory is the dynamic random access memory (DRAM) as non-volatile memory. The information in DRAM is retained by a capacitor and it is addressed by a transistor in a so-called 1T-1C memory cell. The capacitor is charged by application of a "write" pulse and then is destructively read by discharging this capacitor in an external circuit. In order to maintain a detectable signal a minimum capacitance is needed for the storage capacitor of the memory cell. The low density memory cell have used planar capacitors and, as the density has been standing increased by a factor of four every three years, 3D capacitor concepts have been developed. The two major architectures are the stacked capacitor, in which the capacitor is situated on top of the transistor, and the trench capacitor, in which the capacitor is fabricated in a thin trench etched in a substrate nearby the transistor.

The stored charge in the cell can be increased by:

1) Increasing the capacitor area
2) Thinning the capacitor dielectric
3) Using higher dielectric constant material for storage dielectric
4) Increasing the voltage on the gate of transfer device
5) Reducing the cell leakage.

There are, however, constraints with these five approaches.

DRAM memories are optimized for low cost and high yield, so that there is a need to minimize the die size as the number of bits per chip increase. While the lithography scaling alone has reduced the die area by a factor of 0.5 per generation, the number of bits per chip has quadrupled during the same period. The technology has therefore focused on decreasing the cell area faster than allowed by lithography to avoid a substantial increase in die area, without decreasing the storage capacitance of the cell. This effort led to the development of three-dimensional cell capacitors, such as trench capacitors built in the silicon surface, and the stacked structures constructed above the silicon surface. With the development in these new structures, the resulting increase in die size is thus limited to only 40 - 50% every three years.

Primary constraints in reducing the node dielectric thickness include dielectric integrity, reliability and leakage. For a given maximum voltage across the insulator, dielectric must be thick enough to keep the electric field below a specified limit. Materials with higher dielectric constants than silicon dioxide have been used where applicable. Examples include oxidized nitride (ON) and oxidized nitride/oxide (ONO), both presently used in DRAM cell capacitors, tantalum oxide ($Ta_2O_5$) and Barium Strontium Titanate (BST), both still in the research and development stage. Considerations such as ease of deposition, thermal stability, integrity, and reliability limit the choices of materials and flexibility in using them.

Cell capacitor leakage must be kept very small to allow longer retention times. Leakage components include sub-threshold leakage, thermal generation of electron-hole pairs, impact ionization, and tunneling. The low leakage requirements impose a delicate balance between unit processes used to fabricate the cell.

Storage node capacitance Cs must be maintained above a critical value, typically 25-30 fF to insure a minimum signal on the bit line. Also the stored charge decays away quickly because of the inherent leakage of the cell. These two requirements give the most basic problems in DRAM since scaling has been continuously made by decreasing the cell size. In order to insure a minimum Cs, either the aspect ratio of the 3D capacitor architecture is required to increase significantly or the dielectric constant of the insulator has to be increased. In the last case, new dielectric materials with higher dielectric permittivity, so-called high-k dielectrics, have to be used instead of $SiO_2$. Hence, the equivalent oxide thickness (EOT) is defined as the thickness of the $SiO_2$ layer that will give the same specific capacitance as the one given by the actual dielectric.

Ferroelectric non-volatile memories (FERAM) are architecturally similar to DRAM memories except that data is encoded by the direction of spontaneous polarization of a ferroelectric layer sandwiched between two metal contacts and forming a ferroelectric capacitor. Whereas the leakage current does not represent a major problem in FERAM, the large cell footprint given by the required large capacitor area is the major hinder in obtaining high-density FERAM.

It is therefore an object of the present invention to provide a memory capacitor structure which has improved characteristics with respect to the capacitance in relation to the capacitor area. It is also an object of the present invention to provide a method for fabricating such a memory capacitor.

These objects are solved by the features of the independent patent claims. The dependent patent claims refer to advantageous embodiments and examples. The dependent claims also describe a memory cell on a semiconductor substrate and a method for fabricating it.

The invention presents a solution to increase the storage capacitor surface which is based on nanowires. The cell architecture is a stacked architecture and the capacitor is fabricated on a nanowire-based template.

More specifically, the invention is related to a nanowire-based memory capacitor, which comprises

- a substrate
- nanowires attached to a portion of the surface of the substrate, said nanowires being oriented substantially perpendicular to the surface of the substrate and said nanowires being made of an electrically conductive or semi-conductive material and thus forming a lower electrode of the capacitor,
- a capacitor insulation layer deposited conformally on the nanowires,
- a layer of an electrically conductive material deposited conformally on the capacitor insulation layer thus forming an upper electrode of the capacitor.

The invention is also related to a method for fabricating a nanowire-based memory capacitor by the steps of

a) providing a substrate and growing nanowires on a portion of the surface of the substrate, said nanowires being oriented substantially perpendicular to the surface of the substrate and said nanowires being made of an electrically conductive or semi-conductive material,

b) depositing a capacitor insulation layer conformally on the nanowires,

c) depositing a layer of an electrically conductive material conformally on the capacitor insulation layer thus forming an upper electrode of the capacitor.

One important advantage of this inventive concept is an increase of the surface of the capacitor which is usable for storing charges (surface gain). An estimation of this surface gain will be given below.

A surface gain can also be obtained in the conventional trench concept. However, it turns out that the processing of a nanowire template, in particular the conformal deposition of layer thereon, is easier than the processing of trenches.

The nanowires may themselves form the lower electrode of the memory capacitor. Alternatively it is possible to deposit an electrically conductive layer onto the nanowires which forms the lower electrode. In particular, this should be done in the case of ferroelectric capacitors which must have certain bottom and top electrode materials such as Pt, $IrO_2$ and $SrRuO_3$.

As used herein, the term nanowire generally refers to any elongated conductive or semi-conductive material that includes at least one cross sectional dimension that is less than 500 nm, and preferably, less than 100 nm, and has an aspect ratio (length:width) of greater than 10, preferably greater than 50, and more preferably, greater than 100. Particularly preferred nanowires include nanowires that are comprised of semiconductor material like an element semiconductor or a compound semiconductor or an appropriate combination of two or more of such semiconductor materials. The semiconductor material of the nanowire may comprise a dopant from a group consisting of a p-type dopant from group III of the periodic table or an n-type dopant from group V of the periodic table.

Although the term nanowire is referred to throughout the description herein for illustrating purposes, it is intended that the descriptions herein also encompass the use of nanotubes. Nanotubes can be formed as it is described herein for nanowires, alone or in combination with nanowires, to provide the properties and advantages described herein.

In the context of the invention, the substrate to which nanowires are attached may comprise a wafer of a uniform solid material such as a semiconductor material like silicon. In particular the substrate to which nanowires are attached is a layer of semiconductor material, in particular a silicon layer.

The nanowires are oriented substantially perpendicular to the surface of the substrate. It is meant therewith that the longitudinal axes of a majority of nanowires in a collection or population of nanowires is oriented within 30 degrees of a single direction. Although the majority can be considered to be a number of nanowires greater than 50%, in various embodiments, 60%, 75%, 80%, 90%, or other percentage of nanowires can be considered to be a majority that is so oriented. In certain preferred embodiments, the majority of nanowires are oriented within 10 degrees of the desired direction. In other embodiments, the majority of nanowires may be oriented within other numbers or ranges of degrees of the desired direction.

In those embodiments in which the substrate onto which the nanowires are to be attached or grown, is a semiconductor substrate or layer the nanowires themselves are preferably also made of a crystalline semiconductor material. In particular the nanowires are then epitaxially grown on the semiconductor layer. In particular the semiconductor layer can be made of silicon and the nanowires can be made of a group IV semiconductor, in particular silicon.

The nanowires can be fabricated by so-called seeded approaches, wherein nanocrystals bound to a substrate are used to promote the growth of the nanowire. These nanocrystals are continuously reacted with a super critical fluid mixture so that the nanocrystals act as catalyst sides for the growth of the nanowires. The super critical fluid mixture may comprise at least one group IV semiconductor precursor so that crystalline group IV semiconductor nanowires grow from the catalyst sites. Such process is described in detail in the United States Patent Application Publication No. US 2005/0029678 A1 which is herewith incorporated in its entirety for all purposes into the present application.

In the publication "The shape of epitaxially grown silicon nanowires and the influence of line tension" by the authors V. Schmidt et al. in Appl. Phys. A 80, 445-450 (2005) the epitaxial growth of silicon nanowires at the locations of gold nanocrystal sites is theoretically described in terms of the so-called vapor-liquid-solid (VLS) growth mechanism and the dependency of the diameter of the nanowires as a function of the height is investigated. This publication is also incorporated in its entirety for all purposes into the present application.

Additional background and theoretical discussion can be found in "Growth of Single Crystal Silicon Nanowires in Supercritical Solution from Tethered Gold Particles on a Silicon Substrate" by Lu et al., Nano-Letters, 2003, Vol. 3, No. 1, 93-99, the entire disclosure of which is incorporated herein by reference.

The capacitor insulator layer can be a dielectric layer for DRAM memory applications. It can also be a ferroelectric layer for FERAM (ferroelectric RAM) memory applications.

If the capacitor insulator layer is a dielectric layer it can be formed by an oxide layer which is conformally grown on the nanowire. If the nanowires are made of semiconductor material the oxide layer could be easily fabricated by oxidizing the semiconductor material of the nanowires. Alternatively the capacitor insulator layer can also be grown as an oxide or nitride layer by, for example, chemical vapor deposition (CVD) or atomic layer deposition (ALD).

If the capacitor insulator layer is a ferroelectric layer it, for example, can be comprised of a metal oxide layer, e.g. $BaTiO_3$, and, for example, can be grown by chemical vapor deposition (CVD) or pulsed laser deposition (PLD).

The present invention also relates to a memory cell having a nanowire-based memory capacitor and a method for fabricating such memory cell.

Such a memory cell comprises

- a semiconductor substrate,
- an MOS transistor provided at the surface of the semiconductor substrate comprising source, drain and gate regions,
- an insulation layer deposited on the substrate above the MOS transistor, and
- a nanowire-based memory capacitor as described above and formed on the insulation layer and connected to one of the source or drain regions of the MOS transistor.

A method for fabricating such a memory cell on a semiconductor substrate comprises the steps of

A) fabricating an MOS transistor at the surface of the semiconductor substrate comprising source, drain and gate regions,
B) depositing an insulation layer on the substrate above the MOS transistor, and
C) fabricating a nanowire-based memory capacitor as described above on the insulation layer and connecting the memory capacitor to one of the source or drain regions of the MOS transistor.

For connecting the memory capacitor to one of the source or drain regions of the MOS transistor it is necessary to form a through-hole into the insulation layer extending from the surface of the insulation layer to one of the source or drain regions. In a preferred embodiment the memory capacitor is formed vertically above one of the source or drain regions which is the so-called COB (capacitor-over-bit) arrangement. In this embodiment it is necessary to form the through-hole into the insulation layer before forming the memory capacitor. After forming the through-hole it is filled with an electrically conductive material, thereafter the surface will be planarized and on the planarized surface above the filled through-hole the memory capacitor is formed. In this embodiment one of the source or drain regions of the MOS transistor is connected with the lower electrode of the memory capacitor.

In an alternative embodiment the memory capacitor is not formed vertically above one of the source or drain regions. A vertical through-hole is formed into the insulation layer extending from the surface of the insulation layer to one of the source or drain regions. This can also be done after the memory capacitor has been formed on the insulation layer. After the through-hole has been formed, it is filled with an electrically conductive material and connected with the upper electrode of the memory capacitor.

In step C) at first a base layer is deposited on the insulation layer, said base layer being the substrate for the subsequent growing of nanowires thereon. The base layer can be made of a semiconductor material, in particular a group IV semiconductor material, in particular silicon.

In the following the invention will be described in more detail in connection with the accompanying drawings which show:

Fig. 1    a perspective view of a memory cell with a first embodiment of a nanowire-based memory capacitor according to the present invention;

Fig. 2a-h    side views of the semiconductor substrate, the MOS transistor and the memory capacitor according to a second embodiment in successive stages of the fabrication of the memory cell.

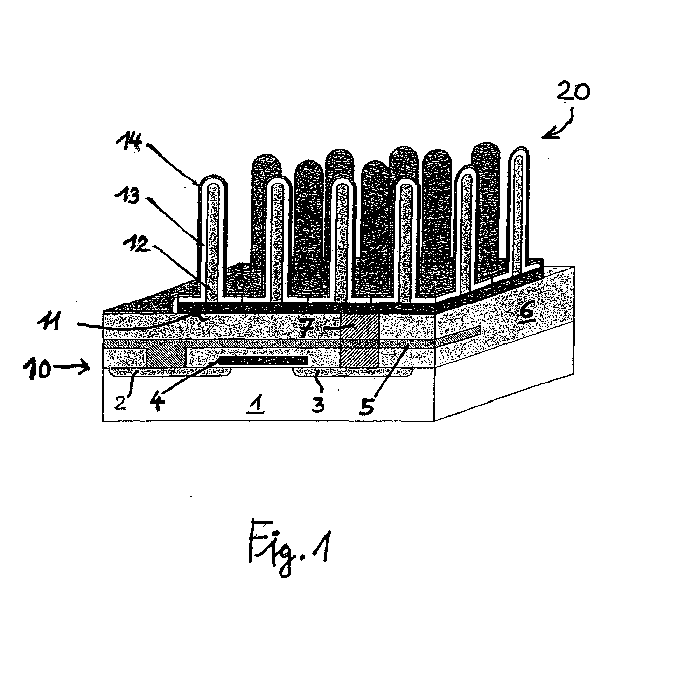

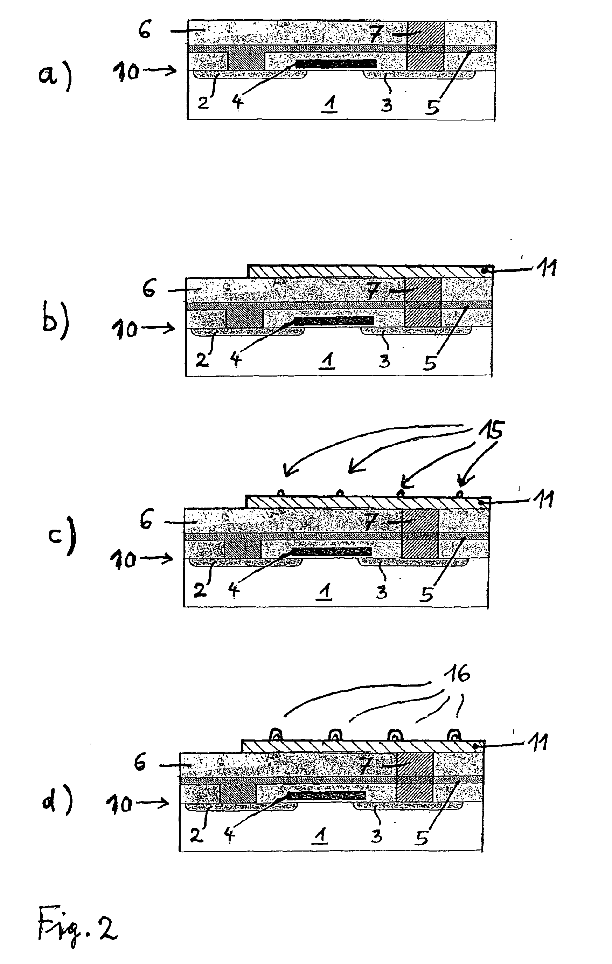

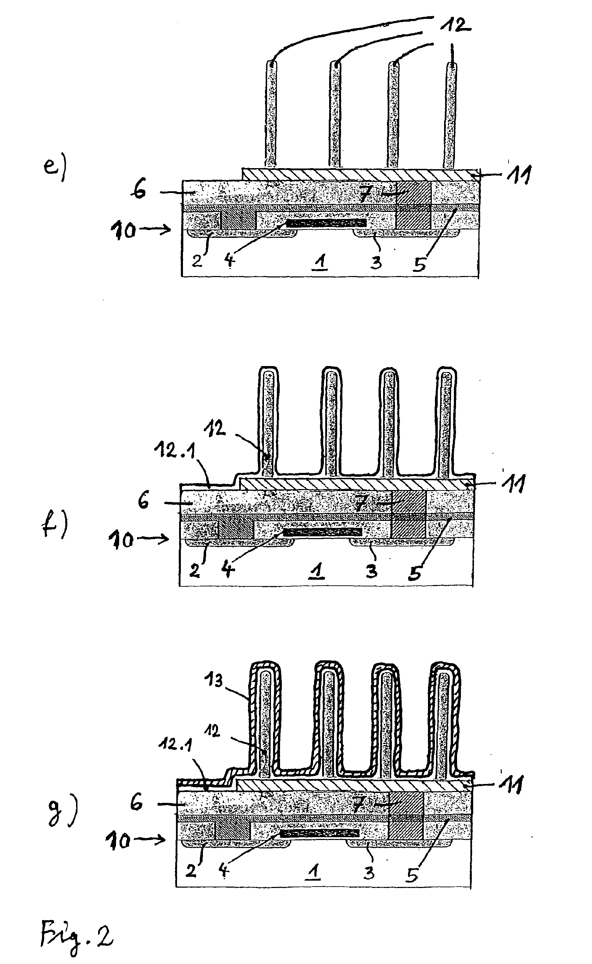

The architecture of the memory cell as depicted in Fig. 1 is a "stacked cell" architecture which means that the capacitor is arranged vertically above the MOS transistor, i.e. vertically over one of the source or drain regions. This cell type is also called capacitor-over-bit (COB) type. However, the invention also covers memory cells of the so-called "offset cell" architecture, in which the capacitor and the transistor are not arranged vertically above each other.

The memory cell is meant to be part of an array of memory cells of a DRAM (or FERAM) memory having word and bit lines in a well-known manner.

Fig. 1 shows a perspective view of a memory cell with a first embodiment of a nanowire-based memory capacitor according to the present invention. In this embodiment the nanowires themselves form the lower electrode of the memory capacitor. In the surface of a silicon substrate 1 a CMOS transistor 10 is formed in a well-known manner comprising a source region 2 and a drain region 3 between which the transistor channel is provided. Above the transistor channel and the surface of the substrate 1, a gate region 4 is formed which is connected with a bit line of the DRAM memory. The source region 2 is connected with the word line 5 of the DRAM memory. After fabricating the CMOS transistor an insulation layer 6 is deposited thereon. A vertical through-hole contact 7 is formed in the insulation layer 6 extending from the upper surface of the insulation layer 6 down to the drain region 3. The insulation layer 6 can be, for example, a silicon oxide or silicon nitride layer.

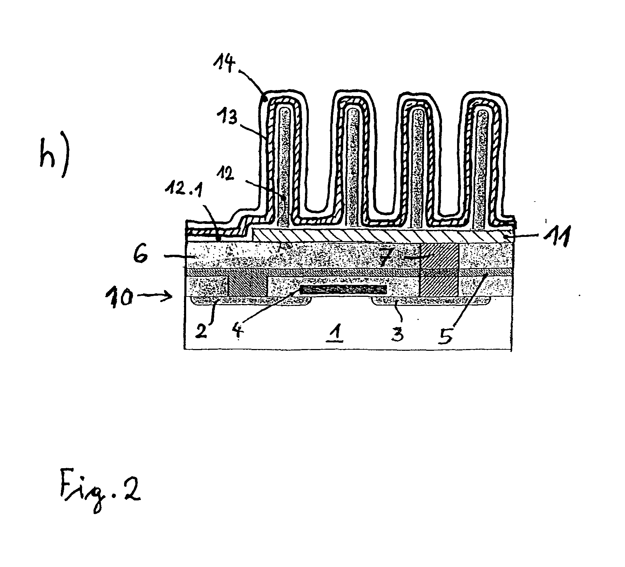

It is to be noted that the word line 5 and the through-hole contact 7 are not in electrical contact with each other as it might appear in the views of Figs. 1 and 2a-2h.

On the insulation layer 6 a nanowire-based memory capacitor 20 is arranged consisting of a silicon layer 11, silicon nanowires 12, a capacitor insulation layer 13 and a top electrode layer 14. The silicon nanowires 12 form themselves the lower electrode of the memory capacitor in the first embodiment as shown in Fig.1.

In the following the process steps for fabricating a memory capacitor according to a second embodiment of the present invention are described with respect to Figs. 2a-h.

In Fig. 2a a situation is shown in which the MOS transistor has been fabricated in the semiconductor substrate 1, the source 2 and the gate 4 have been contacted with the word line and with the bit line, respectively, the insulation layer 6 has been deposited and the through-hole contact 7 has been formed extending from the upper surface of the insulation layer 6 and the drain region 3.

Afterwards on top of the insulation layer 6 a thin crystalline silicon layer 11 is deposited by any known deposition process like, for example, chemical vapor deposition (Fig. 2b).

The silicon layer 11 must have a sufficient electrical conductivity to provide for an electrical conduction path between the contact 7 and the nanowires which are to be grown on the silicon layer 11. Therefore the silicon layer 11 contains dopant atoms and the doping is performed either during growth or afterwards.

Then silicon nanowires 12 are epitaxially grown by utilizing methods and processes as reported in the literature such as that described in the US patent application publication No. US 2005/0029678 A1 or in the German language article "Nanodrähte" in "Physik Journal", Mai 2005, pages 29 to 34 by M. Zacharias and P. Werner.

At first gold nanocrystals 15 are deposited on the surface of the silicon layer 11 to such an extent that only a few percent of the surface are covered by the gold nanocrystals 15 (Fig. 2c). These gold nanocrystals 15 act as catalyst sites for the subsequent growth of the silicon nanowires. It is also possible to use nanocrystals of other metals than gold.

Subsequently a supercritical fluid mixture comprising a silicon precursor is brought into contact with the surface of the silicon layer 11 and the gold nanocrystals 15 at a reaction temperature of 350°C to about 800°C. The silicon precursor can, for example, be an organometallic silicon precursor like diphenyl silane. As a first result droplets 16 are formed at the sites of the gold nanocrystals, these droplets 16 comprising a eutectic mixture of gold and silicon (Fig. 2d).

The Au/Si-eutectic droplets 16 grow further as silicon atoms of the precursor gas attach on them. When precursor molecules of the precursor gas will reach the surface of the droplet nearly all of them will be adhered thereto since the adsorption coefficient is near to 1. The precursor molecules will be broken at the droplet surface and silicon atoms move into the Au/Si-eutectic droplet 16. Depending on the process parameters like e.g. the temperature this will lead to a supersaturation of the silicon component within the droplet. The result is that silicon atoms will precipitate at the liquid/solid boundary between the liquid droplet 16 and the solid surface. In this way the silicon nanowires 12 will grow.

The growth occurs nearly exclusively in the vertical direction. In this way silicon nanowires 12 are produced and the growth will be terminated when the height of the silicon nanowires 12 has reached a desired value (Fig. 2e).

Due to the second embodiment the silicon nanowires 12 are not supposed to form themselves the lower electrode of the memory capacitor. Instead a further electrode layer will be deposited onto the silicon nanowires 12. In any case the silicon material of the silicon nanowires 12 must have a sufficient electrical conductivity, i.e. doping level. The doping of the silicon nanowires 12 may happen during the growth process, for example by adding an adequate doping agent to the precursor gas. Alternatively the doping of the silicon nanowires 12 may happen after the growth process, for example by well-known diffusion or implantation processes.

After the growth of the silicon nanowires 12 a lower electrode layer 12.1 will be deposited by any deposition method known in the art as is shown in Fig.2f. In case of a dielectric capacitor the lower electrode layer 12.1 can be made of e.g. Poly-Si, Au, Cu, Al or W or any other suitable electrically conductive material. In case of a ferroelectric capacitor the lower electrode layer 12.1 can be made of e.g. Pt, $IrO_2$ or $SrRuO_3$. As explained above the step of depositing a lower electrode layer 12.1 is not absolutely necessary, in particular in the case of normal dielectric capacitors.

Afterwards a capacitor insulation layer 13 is deposited conformally onto the lower electrode layer 12.1 or the nanowires 12 so that the capacitor insulation layer 13 substantially covers the surfaces of all nanowires 12 and substantially comprises a constant thickness at each point on the nanowires surfaces or in-between the nanowires 12. For achieving this the silicon nanowires 12 and the surface of the silicon layer 11 in-between the nanowires 12 may be, for example, thermally oxidized so that a silicon oxide layer is grown on the surfaces of the nanowires 12 and the silicon layer 11 in case that no lower electrode layer 12.1 has been deposited in the method step before. Alternatively other processes like chemical vapor deposition (CVD) or atomic layer deposition (ALD) could be used for depositing the capacitor insulation layer 13. In particular, if ferroelectric or high-k materials are to be deposited it might be useful to employ other processes like, for example, pulsed laser deposition (PLD). In particular metal oxides like e.g. $BaTiO_3$ can be deposited by the pulsed laser deposition method. The result is shown in Fig.2g.

Afterwards the top metal layer 14 which is the upper electrode layer of the memory capacitor is conformally deposited onto the capacitor insulator layer 13. As an example Pt can be deposited as metal layer 14 by using the RF magnetron sputtering method. The result is shown in Fig.2h.

It has been indicated above that one advantage of the present invention lies in the surface gain which can be achieved with the nanowire-based memory capacitor.

The actual surface gain can be calculated assuming the cell footprint is fully the same as the capacitor base and is covered with nanowires with diameter d and length l that would give the aspect ratio $R_a = 1/d$. For instance, a nanowire with a 30 nm diameter and 600 nm length has an aspect ratio of 20. The gain in the capacitor surface is given by the lateral size of all nanowires as follows:

$$S_{nw} = 2\pi d \times l \times n \qquad\qquad (1)$$

where $2\pi d$ is the lateral perimeter of each one of the nanowires, l their respective length and n the total number of nanowires contained in the capacitor memory. In order to simplify it can be considered an ordered array of nanowires, although this is not necessarily the case, so that the average distance between the nanowires is equal to their diameter, so the total number of nanowires is:

$$n = (L/2d)^2 = L^2/4d^2 \qquad\qquad (2)$$

where L is the lateral size of the DRAM cell. The additional surface is given by:

$$S_{nw} = \pi/2\ L^2\ R_a \qquad\qquad (3)$$

The gain in the cell surface in the stacked architecture is simply the ratio between the surface with and without the nanowire, the last being given by $L^2$:

$$G_{stacked} = S_{nw}/S = \pi/2\ R_a \qquad\qquad (4)$$

For the conventional trench architecture, the capacitor surface is given by the lateral surface of the trench:

$$S_{trench} = 2\pi d_{trench} \times l_{trench} = 2\pi (d_{trench})^2\ R_a^{trench} \qquad\qquad (5)$$

The gain in surface is

$$G_{trench} = S_{nw}/S_{trench} = 1/4 \ (L/d_{trench}{}^2 \ R_a/R_a{}^{trench} \qquad (6)$$

or considering the cell size factor defined in the ITRS road map 2003 as

$$a = (Cell \ size)/F^2 \ (F: \ minimum \ feature \ size) \ or \ L^2 = aF^2 \qquad (7)$$

and the trench diameter scaling with the feature size F:

$$(d_{trench}) = b \ F \qquad (8)$$

b being the scale factor of the trench and is usually about 1.5. The surface gain is now:

$$G_{trench} = a/4b^2 \ R_a/R_a{}^{trench} \qquad (9)$$

Considering values for the size and scale factor, a = 8 and b = 1.25 according to the ITRS 2003 road map, so the surface gain for the trench architecture is:

$$G_{trench} = S_{nw}/S_{trench} = 1.28 \ R_a/R_a{}^{trench} \ . \qquad (10)$$

The surface gain for the stacked and trench cell architecture given by (4) and (10) for nanowires with an aspect ratio of about 20 is $G_{stacked}$ = 31.4 and $G_{trench}$ = 0.64, respectively. For the stacked architecture the surface gain is considerable whereas for the trench architecture there is no gain. In the last case the surface gain is considerable only if the aspect ration is equal with the aspect ratio of the trench or the number of nanowires is high, i.e. the covering is higher that the simple regular array considered in the above calculations. For instance, considering an aspect ratio of 50 for the nanowires (20 nm diameter and 1 $\mu$m length) and 40 for a trench the gain would be 12.8, which is significant.

Advantages of using nanowire-based solution are not only in gaining of storage capacitor surface, but also in processing: conformal deposition by CVD- and PVD-based methods is much easier performed on positive templates (wires) than on negative templates (trenches). Gaining in capacitor surface will mean that the conventional insulation material $SiO_2$ can be used another 1-3 generations, depending on the actual surface gain, as dielectric material. The whole fabrication process as described in the above embodiment according to Figs. 1 and 2a-g is using only CMOS-compatible materials.

The inventive concept can be easily applied to fabricate also non-volatile ferroelectric memories by depositing a ferroelectric layer on the nanowires.

The nanowires can also be fabricated from other materials like metals or semimetals. Processes for fabricating such nanowires are also well-known in the literature.

**Claims**

1. A nanowire-based memory capacitor (20), comprising

    - a substrate (11),
    - nanowires (12) attached to a portion of the surface of the substrate (11), said nanowires (12) being oriented substantially perpendicular to the surface of the substrate (11), and said nanowires (12) being made of an electrically conductive or semi-conductive material,
    - a capacitor insulation layer (13) deposite conformally onto the nanowires (12),

- a layer (14) of an electrically conductive material deposited conformally onto the capacitor insulation layer (13) thus forming an upper electrode of the capacitor (20).

2. A memory capacitor according to claim 1,
   **characterized in that**

   - the nanowires (12) are made of crystalline material, in particular the nanowires (12) are epitaxially grown on the substrate (11).

3. A memory capacitor according to one of claims 1 or 2,
   **characterized in that**

   - the nanowires (12) are made of semiconductor material, in particular group IV semiconductor material, in particular silicon.

4. A memory capacitor according to one of the preceding claims,
   **characterized in that**

   - the capacitor insulator layer (13) is a dielectric layer, in particular the oxide of the semiconductor material of the nanowires (12), or a ferroelectric layer, in particular in the form of a metal oxide.

5. A memory cell, comprising

   - a semiconductor substrate (1),
   - an MOS transistor (10) provided at the surface of the semiconductor substrate (1) comprising source (2), drain (3) and gate regions (4),
   - an insulation layer (6) deposited on the substrate (1) above the MOS transistor (10),
   - a memory capacitor (20) according to one of the preceding claims formed on the insulation layer (6).

6. A method for fabricating a nanowire-based memory capacitor (20) by the steps of

   a) providing a substrate (11) and growing nanowires (12) on a portion of the surface of the substrate (11), said nanowires (12) being oriented substantially perpendicular to the surface of the substrate (11) and said nanowires being made of an electrically conductive or semi-conductive material thus forming a lower electrode of the capacitor (20),
   b) depositing a capacitor insulation layer (13) conformally onto the nanowires (12),
   c) depositing a layer (14) of an electrically conductive material conformally onto the capacitor insulation layer (13) thus forming an upper electrode of the capacitor (20).

7. A method according to claim 6,
   **characterized in that**

   - in step a) crystalline nanowires (12) are grown, in particular crystalline nanowires (12) are grown epitaxially on the surface of the substrate (11).

8. A method according to anyone of claims 6 or 7,
   **characterized in that**

   - in step a) the nanowires (12) are made of semiconductor material, in particular group IV material, in particular silicon.

9. A method according to anyone of claims 6 to 8,
   **characterized in that**

   - in step a) catalyst sites (15) are attached to the substrate surface, said catalyst sites (15) are continuously reacted with a supercritical fluid mixture comprising at least one group IV semiconductor precursor, whereby crystalline group IV semiconductor nanowires (12) grow from the catalyst sites (15).

**10.** A method according to claim 9,
**characterized in that**

   - the catalyst sites (15) comprise metallic nanocrystals, in particular gold nanocrystals.

**11.** A method according to claims 6 and 8,
**characterized in that**

   - in step b) the capacitor insulation layer (13) is formed as a dielectric layer, in particular by oxidizing the semiconductor material of the nanowires (12), or as a ferroelectric layer, in particular in the form of a metal oxide.

**12.** A method according to anyone of claims 6 to 11,
**characterized in that**

   - in step b) the insulation layer is formed by chemical vapor deposition (CVD) or atomic layer depositon (ALD).

**13.** A method according to anyone of claims 6 to 12,
**characterized in that**

   - in step c) the layer (14) of the upper electrode is formed by RF magnetron sputtering.

**14.** A method for fabricating a memory cell on a semiconductor substrate (1) by the steps of

   A) fabricating an MOS transistor (10) at the surface of the semiconductor substrate (1) comprising source (2), drain (3) and gate regions (4),
   B) depositing an insulation layer (6) on the substrate (1) above the MOS transistor (10),
   C) fabricating a memory capacitor (20) on the insulation layer (6) according to anyone of claims 6 to 13 and connecting the memory capacitor (20) to one of the source (2) or drain regions (3).

**15.** A method according to claim 14,
**characterized in that**

   - in step C) on the insulation layer (6) a base layer (11) of the memory capacitor (20) is deposited, said base layer (11) serving as the substrate (11) for the subsequent growing of said nanowires (12) thereon.

**16.** A method according to anyone of claims 14 or 15,
**characterized in that**

   - said base layer (11) is made of silicon.

Fig. 1

Fig. 2

e)

f)

g)

**Fig. 2**

h)

Fig. 2

**European Patent Office**

**EUROPEAN SEARCH REPORT**

Application Number

EP 05 01 0955

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PATENT ABSTRACTS OF JAPAN vol. 2003, no. 12, 5 December 2003 (2003-12-05) & JP 2004 146520 A (FUJITSU LTD), 20 May 2004 (2004-05-20) * abstract * * figures 5,6 * | 1-8,11, 14 | G11C13/00 G11C11/401 |
| Y | | 9,10,12, 13,15,16 | |
| X | WO 2005/038814 A (INFINEON TECHNOLOGIES AG; DUESBERG, GEORG, STEFAN; GRAHAM, ANDREW; KRE) 28 April 2005 (2005-04-28) * figures 1,2 * * page 4, line 32 - page 5, line 30 * * page 7, line 11 - page 9, line 6 * | 1-4,6-8, 11,12 | |
| Y | | 12,13, 15,16 | |
| Y | EP 1 440 932 A (CANON KABUSHIKI KAISHA) 28 July 2004 (2004-07-28) * paragraphs [0061] - [0114]; figure 1 * | 9,10 | |
| | | | TECHNICAL FIELDS SEARCHED (IPC) |
| P,X | JANG J ET AL: "Nanoscale capacitors based on metal-insulator-carbon nanotube-metal structures" APPLIED PHYSICS LETTERS, AIP, AMERICAN INSTITUTE OF PHYSICS, MELVILLE, NY, US, vol. 87, no. 26, 21 December 2005 (2005-12-21), pages 263103-263103, XP012077102 ISSN: 0003-6951 * the whole document * | 1 | G11C C01B B01J |

The present search report has been drawn up for all claims

| Place of search | Date of completion of the search | Examiner |
|---|---|---|
| Munich | 6 March 2006 | Stocken, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**  EP 05 01 0955

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2006

| Patent document cited in search report | Publication date | Patent family member(s) | | Publication date |
|---|---|---|---|---|
| JP 2004146520 A | 20-05-2004 | NONE | | |
| WO 2005038814 A | 28-04-2005 | DE | 10344814 B3 | 14-07-2005 |
| EP 1440932 A | 28-07-2004 | CN | 1572723 A | 02-02-2005 |
| | | US | 2005079119 A1 | 14-04-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050029678 A1

**Non-patent literature cited in the description**

- **V. SCHMIDT et al.** *Appl. Phys. A,* 2005, vol. 80, 445-450
- **LU et al.** Growth of Single Crystal Silicon Nanowires in Supercritical Solution from Tethered Gold Particles on a Silicon Substrate. *Nano-Letters,* 2003, vol. 3 (1), 93-99
- **M. ZACHARIAS ; P. WERNER.** *Physik Journal,* May 2005, 29-34